# EUROPÄISCHE PATENTANMELDUNG

(11) **EP 2 133 881 A1**
(43) Veröffentlichungstag der Anmeldung: **16.12.2009**
(21) Anmeldenummer: 09007531.8
(22) Anmeldetag: 08.06.2009
(51) Int. Cl.: G11C 5/14

(54) **Schaltung und Verfahren zum Betrieb einer Schaltung**

(30) Priorität: 09.06.2008 DE 102008027392
(71) Anmelder: Atmel Automotive GmbH, 74072 Heilbronn (DE)
(72) Erfinder: Ferchland, Tilo, Dipl.-Ing., 01277 Dresden (DE); Kluge, Wolfram, Dr.-Ing., 01109 Dresden (DE); Zarbock, Jeannette, Dipl.-Ing., 01109 Dresden (DE)
(74) Vertreter: Müller, Wolf-Christian

(57) **Zusammenfassung**

Schaltung und Verfahren zum Betrieb einer Schaltung,
- mit einer Teilschaltung (300), die eine Anzahl von Speicherelementen (311, 312, 313) aufweist,
- mit einem ersten Spannungsregler (100), der zum Betrieb der Teilschaltung (300) mit der Teilschaltung (300) verbindbar oder verbunden ist,
- mit einem zweiten Spannungsregler (200), der zum Erhalt einer in den Speicherelementen (311, 312, 313) enthaltenen Information mit der Teilschaltung (300) verbindbar oder verbunden ist,
- mit einer mit der Teilschaltung (300) verbundenen Schaltvorrichtung (400), die zur Deaktivierung und Aktivierung von Eingängen (E1, E2, E3) der Teilschaltung (300) ausgebildet ist,
- wobei die Schaltung ausgebildet ist die Deaktivierung und Aktivierung der Eingänge (E1, E2, E3) der Teilschaltung (300) zu steuern, und
- wobei die Teilschaltung (300) ausgebildet ist eine Deaktivierung und Aktivierung des ersten Spannungsreglers (100) mittels eines Steuersignals (en_vdd) zu steuern.

## Beschreibung

Die vorliegende Erfindung betrifft eine Schaltung und ein Verfahren zum Betrieb einer Schaltung.

Digitale Schaltungen können in einen Betriebsmodus zur Informationsverarbeitung und in einen Ruhemodus (engl. sleep mode oder standby) mit gegenüber dem Betriebsmodus reduziertem Stromverbrauch gesteuert werden. Der Informationsinhalt in Speicherelementen der digitalen Schaltungen kann dabei erhalten bleiben, wenn die Speicherelemente auch im Ruhemodus mit einer Spannung versorgt werden. Hierzu können beispielsweise eine Batterie und/oder ein Akkumulator vorgesehen sein, welche im Ruhemodus mit den Speicherelementen verbunden sind.

Aus der US 4,683,382 ist ein Halbleiterbauelement mit einem ersten und einem zweiten Spannungsreduzierungsschaltkreis bekannt. Die Spannungsreduzierungsschaltkreise erzeugen eine Ausgangsspannung kleiner als eine extern angelegte Versorgungsspannung. Der erste Spannungsreduzierungsschaltkreis verbraucht weniger Leistung ist stets aktiv. Der zweite Spannungsreduzierungsschaltkreis verbraucht mehr Leistung als der erste Spannungsreduzierungsschaltkreis und ist außer in einem Standby-Interval aktiv. Beide Spannungsreduzierungsschaltkreise sind zur Versorgung eines Speicherschaltkreises parallel an eine Versorgungsleitung angeschlossen.

Der Erfindung liegt die Aufgabe zu Grunde eine Schaltung möglichst zu verbessern.

Diese Aufgabe wird durch Schaltung mit den Merkmalen des unabhängigen Anspruchs 1 gelöst. Vorteilhafte Weiterbildungen sind Gegenstand von abhängigen Ansprüchen und in der Beschreibung enthalten.

Demzufolge ist eine Schaltung vorgesehen, die vorzugsweise auf einem Halbleiterchip monolithisch integriert ist.

Die Schaltung weist eine Teilschaltung auf, wobei die Teilschaltung eine Anzahl von insbesondere flüchtigen Speicherelementen, wie beispielsweise Register, Latches oder Flip-Flops aufweist.

Die Schaltung weist einen ersten Spannungsregler auf, der zum Betrieb der Teilschaltung mit der Teilschaltung insbesondere über einen Schalter verbindbar oder fest verbunden ist.

Die Schaltung weist einen zweiten Spannungsregler auf, der zum Erhalt einer in den Speicherelementen enthaltenen Information mit der Teilschaltung insbesondere über einen Schalter verbindbar oder fest verbunden ist.

Die Schaltung weist eine Schaltvorrichtung auf, die mit der Teilschaltung verbunden ist. Die Schaltvorrichtung ist zur Deaktivierung und Aktivierung von Eingängen der Teilschaltung ausgebildet. Zur Deaktivierung und Aktivierung ist die Schaltvorrichtung den Eingängen der Teilschaltung vorteilhafterweise vorgeschaltet. Vorzugsweise weist die Schaltvorrichtung Schaltmittel, wie Halbleiterschalter und/oder Logikelemente und/oder schaltbare Pegelschieber zur Aktivierung und Deaktivierung der Eingänge auf.

Die Schaltung ist ausgebildet eine Deaktivierung und Aktivierung des ersten Spannungsreglers und die Deaktivierung und Aktivierung der Eingänge der Teilschaltung zu steuern. Die Teilschaltung ist zur Steuerung des ersten Spannungsreglers insbesondere zur Deaktivierung und Aktivierung des ersten Spannungsreglers mittels eines Steuersignals ausgebildet und vorzugsweise eingerichtet. Zusätzlich kann die Schaltung weitere Steuermittel zur Steuerung aufweisen.

Der Erfindung liegt weiterhin die Aufgabe zu Grunde ein möglichst verbessertes Verfahren anzugeben.

Diese Aufgabe wird durch das Verfahren mit den Merkmalen des unabhängigen Anspruchs 10 gelöst. Vorteilhafte Weiterbildungen sind Gegenstand von abhängigen Ansprüchen und in der Beschreibung enthalten.

Demzufolge ist ein Verfahren zum Betrieb einer Schaltung vorgesehen.

Für einen Ruhemodus werden Eingänge einer Teilschaltung der Schaltung deaktiviert, wobei die Teilschaltung eine Anzahl von Speicherelementen aufweist. Vorzugsweise sind die Eingänge für in die Teilschaltung eingehende Informationen - wie beispielsweise einzelne Bits oder seriell oder parallel übertragene Bitwörter - ausgebildet und eingerichtet. Zur Deaktivierung wird vorzugsweise der Eingangswert auf ein festes vorbestimmtes logisches Potential beispielsweise Null oder Eins geschaltet.

Ein erster Spannungsregler wird nach der Deaktivierung der Eingänge der Teilschaltung durch die Teilschaltung selbst deaktiviert, so dass die Speicherelemente der Teilschaltung von einem zweiten Spannungsregler versorgt werden. Vorzugsweise wird der erste Spannungsregler zur Deaktivierung stromlos geschalten.

Für einen dem Ruhemodus folgenden Betriebsmodus wird der erste Spannungsregler von der Teilschaltung selbst aktiviert um die Teilschaltung zu versorgen. Der Betriebsmodus weist gegenüber dem Ruhemodus einen erhöhten Stromverbrauch auf, insbesondere um eine Vielzahl von Funktionen, insbesondere Verfahrensschritte eines Programmablaufs, auszuführen.

Für den Betriebsmodus werden die Eingänge der Teilschaltung nach der Aktivierung des ersten Spannungsreglers aktiviert, insbesondere um über die Eingänge eingehende Informationen von der Teilschaltung zu verarbeiten.

Der Erfindung liegt weiterhin die Aufgabe zu Grunde eine Verwendung anzugeben.

Diese Aufgabe wird durch eine Verwendung mit den Merkmalen des unabhängigen Anspruchs 11 gelöst. Vorteilhafte Weiterbildungen sind Gegenstand von abhängigen Ansprüchen und in der Beschreibung angegeben.

Demzufolge ist eine Verwendung eines ersten Spannungsreglers für einen Betriebsmodus und eines zweiten Spannungsreglers für einen Ruhemodus vorgesehen. Der erste Spannungsregler und der zweite Spannungsregler sind vorzugsweise Bestandteile ein und derselben monolithisch integrierten Schaltung. Die Informationsverarbeitung ist in dem Betriebsmodus gegenüber dem Ruhemodus signifikant erhöht. Im Ruhemodus ist der Stromverbrauch gegenüber dem Betriebsmodus signifikant reduziert. Der Speicherinhalt von Speicherelementen der Schaltung wird im Ruhemodus vorzugsweise nicht verändert.

Der erste Spannungsregler einer Schaltung stellt im Betriebsmodus eine Versorgungsspannung und einen Betriebsstrom für eine Teilschaltung der Schaltung bereit.

Der zweite Spannungsregler der Schaltung stellt für den Ruhemodus eine Ruhespannung und einen Ruhestrom für die Teilschaltung bereit.

Der zweite Spannungsregler weist einen geringeren Stromverbrauch auf als der erste Spannungsregler der Schaltung. Vorzugsweise ist der erste Spannungsregler spezifisch zur Bereitstellung des Betriebsstroms ausgebildet. Vorzugsweise ist der zweite Spannungsregler spezifisch zur Bereitstellung des Ruhestromes ausgebildet. Vorzugsweise ist der Ruhestrom gegenüber dem Betriebsstrom um zumindest den Faktor 100 kleiner.

Der erste Spannungsregler wird durch die Teilschaltung aktiviert und deaktiviert.

Die beschriebenen Weiterbildungen beziehen sich sowohl auf die Schaltung, als auch auf die Verwendung als auch auf das Verfahren.

Gemäß einer bevorzugten Weiterbildung ist die Schaltung ausgebildet einen Betriebsmodus mit digitalen Zustandswechseln der Teilschaltung und einen Ruhemodus mit keinem digitalen Zustandswechsel oder einer gegenüber dem Betriebsmodus reduzierten Anzahl von digitalen Zustandswechseln zu steuern. Vorteilhafterweise ist der Stromverbrauch im Ruhemodus gegenüber dem Betriebsmodus reduziert.

Gemäß einer vorteilhaften Weiterbildungsvariante weist die Schaltung eine weitere Teilschaltung auf. Vorzugsweise ist die weitere Teilschaltung mit Eingängen und/oder Ausgängen der Teilschaltung verbunden. Insbesondere ist im Betriebsmodus der Stromverbrauch der weiteren Teilschaltung größer als der der Teilschaltung. Vorzugsweise weist die weitere Teilschaltung Funktionen zum Senden und Empfangen von per Funk übertragenen Signalen, insbesondere eine digitale Signalverarbeitung auf.

Bevorzugt weist die Schaltung einen Schalter auf, der mit der weiteren Teilschaltung und dem zweiten Spannungsregler verbunden ist. Zusätzlich kann der Schalter auch mit dem ersten Spannungsregler verbunden oder verbindbar sein. Bevorzugt ist die Schaltung ausgebildet den Schalter für den Ruhemodus zur Trennung der weiteren Teilschaltung vom zweiten Spannungsregler anzusteuern.

In einer anderen Weiterbildung ist vorgesehen, dass die Schaltvorrichtung eine Anzahl von schaltbaren Pegelschiebern aufweist. Vorzugsweise weist die Schaltung Bauelemente auf, die für zumindest zwei unterschiedliche Spannungen - beispielsweise 3,3 V und 1,8 V spezifiziert sind. Die Pegelschieber sind vorzugsweise ausgebildet und verschaltet; Informationen von und zu einer der Teilschaltungen zwischen unterschiedlichen Logikpegeln an deren Eingängen umzusetzen.

In einer anderen Weiterbildung weist die Schaltung eine Rücksetzeinrichtung auf, die zur Ausgabe von Rücksetzsignalen zum Zurücksetzen der Teilschaltung und/oder der weiteren Teilschaltung ausgebildet ist. Bevorzugt ist die Rücksetzeinrichtung ausgebildet die Schaltvorrichtung mittels Steuersignale zu steuern.

Gemäß einer vorteilhaften Ausgestaltung ist vorgesehen, dass die Rücksetzeinrichtung mit dem ersten Spannungsregler verbunden ist. Vorzugsweise ist die Rücksetzeinrichtung ausgebildet den ersten Spannungsregler zu aktivieren bei einem erstmaligen Anlegen einer Eingangsspannung - insbesondere einer Batteriespannung - an die Schaltung.

In einer anderen vorteilhaften Ausgestaltung weist die Rücksetzeinrichtung ein Speicherelement auf, dessen Speicherwert ein erstmaliges Anlegen einer Eingangsspannung an die Schaltung repräsentiert.

Vorzugsweise ist die Rücksetzeinrichtung zur Freigabe einer Aktivierung des ersten Spannungsreglers durch die Teilschaltung ausgebildet. Vorzugsweise erfolgt die Freigabe nach dem erstmaligen Anlegen einer Eingangsspannung.

Gemäß einer besonders bevorzugten Ausgestaltung ist vorgesehen, dass nur der erste Spannungsregler der beiden Spannungsregler eine Regelschleife aufweist, die mit einem Versorgungsspannungsausgang des ersten Spannungsreglers - insbesondere über einen Spannungsteiler - verbunden ist Vorzugsweise ist der erste Spannungsteiler mit einer Referenzspannungsquelle verbunden. Bevorzugt ist die Referenzspannungsquelle eine Bandgab-Referenzspannungsquelle. Vorzugsweise weist der zweite Spannungsregler eine eigene Stromreferenz auf. Der zweite Spannungsregler erzeugt also einen eigenen Bias-Strom (engl. self bias). Die Stromreferenz des zweiten Spannungsreglers weist eine geringere Genauigkeit und Konstanz auf als die Bandgab-Referenzspannungsquelle des ersten Spannungsreglers. Vorzugsweise weist der zweite Spannungsregler eine Strom-Spannungswandlung zur Generierung der Versorgungsspannung aus dem Bias-Strom auf. Vorzugsweise ist der zweite Spannungsregler dem ersten Spannungsregler parallel geschaltet, so dass die Ausgänge des ersten Spannungsreglers und des zweiten Spannungsreglers miteinander verbunden sind. Bevorzugt weist der zweite Spannungsregler dabei ein Mittel auf, das als Diode wirkt. Vorteilhafterweise weist der zweite Spannungsregler einen Transistor auf, der als Emitterfolger oder Sourcefolger geschaltet ist. Der Transistor wirkt dabei als Diode, so dass kein signifikanter Strom in Sperrrichtung der Diode in den zweiten Spannungsregler hineinfließt.

Die zuvor beschriebenen Weiterbildungsvarianten sind sowohl einzeln als auch in Kombination besonders vorteilhaft. Dabei können sämtliche Weiterbildungsvarianten untereinander kombiniert werden. Insbesondere ergeben sich Weiterbildungen des Verfahrens und der Verwendung aus den Funktionen der Schaltung. Einige mögliche Kombinationen sind in der Beschreibung der Ausführungsbeispiele der Figuren erläutert. Diese dort dargestellten Möglichkeiten von Kombinationen der Weiterbildungsvarianten sind jedoch nicht abschließend.

Im Folgenden wird die Erfindung durch Ausführungsbeispiele anhand zeichnerischer Darstellungen näher erläutert.

### Dabei zeigen

- Fig. 1: ein erstes schematisches Blockschaltbild einer Schaltung,
- Fig. 2: ein zweites schematisches Blockschaltbild einer Schaltung,
- Fig. 3: ein schematisches Blockschaltbild einer Rücksetzschaltung, und
- Fig. 4: ein schematisches Blockschaltbild zweier Spannungsregler.

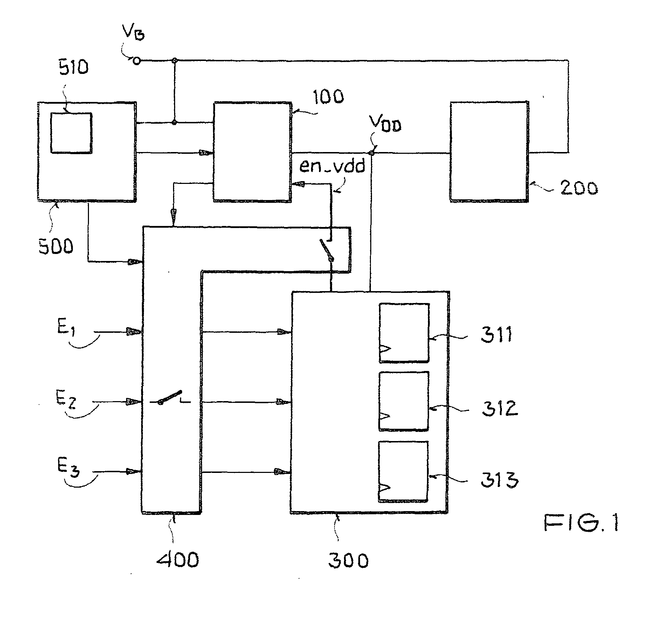

In Fig. 1 ist eine Schaltung durch ein Blockschaltbild schematisch dargestellt. Eine digitale Teilschaltung 300 weist eine Anzahl von Speicherzellen 311, 312, 313, wie beispielsweise Flip-Flops oder Register auf. Die Speicherzellen 311, 312, 313 sind dabei flüchtig, so dass ohne eine angelegte Versorgungsspannung VDD die in den Speicherzellen 311, 312, 313 gespeicherte Information verloren geht. Die Schaltung im Ausführungsbeispiel der Fig. 1 wird mit einer Batteriespannung VB versorgt.

Diese Batteriespannung VB kann beispielsweise in einem Spannungsbereich bis 3,6 V variieren. Die digitale Teilschaltung 300 weist hingegen Bauelemente auf, die für eine geringere Versorgungsspannung VDD von nominal 1,8 V bis maximal 2,0 V spezifiziert sind.

Ein erster Spannungsregler 100 ist mit der Batteriespannung VB verbunden. Der erste Spannungsregler 100 ist ausgebildet an seinem Ausgang die Versorgungsspannung VDD für die digitale Teilschaltung 300 bereitzustellen. Der erste Spannungsregler 100 ist dabei zur Ausgabe eines Versorgungsstroms für die digitale Teilschaltung 300 für einen Betriebsmodus ausgebildet. Im Betriebsmodus führt die digitale Teilschaltung 300 Schritte einer Informationsverarbeitung, also beispielsweise einer Berechnung, Speicherung oder dergleichen aus. Hierzu ändern sich logische Werte von digitalen Elementarzellen, wie Gatter, Flip-Flops oder dergleichen, wobei diese Zustandswechsel eine Ladung und Entladung von Kapazitäten bewirkt. Ein Gesamtverschiebungsstrom durch alle Kapazitäten wird dabei vom ersten Spannungsregler 100 durch den Versorgungsstrom zur Verfügung gestellt. Für die Regelung der Versorgungsspannung VDD auf einen stabilen Wert benötigt der erste Spannungsregler 100 zudem einen eigenen Betriebsstrom von ca. 100 pA.

Die in Fig. 1 dargestellt Schaltung ist weiterhin in einen Ruhemodus steuerbar. Hierzu weist die Schaltung Mittel auf, die einen Ruhemodus initiieren. Beispielsweise kann der Ruhemodus von der Teilschaltung 100 selbst oder einer verbundenen Schaltung (in Fig. 1 nicht dargestellt) initiiert werden. Im Ruhemodus soll der Stromverbrauch der Schaltung minimiert werden. Beispielsweise liegt der Stromverbrauch bei ca. 0,1 µA um eine lange Batterielebensdauer zu gewährleisten.

Aufgrund des hohen Eigenstromverbrauchs des ersten Spannungsreglers 100 wird dieser im Ruhemodus deaktiviert. Zur Deaktivierung des ersten Spannungsreglers 100 kann dieser beispielsweise mittels eines Schalters (nicht dargestellt) abgeschaltet werden.

Im Ruhemodus sollen die in den Speicherelementen 311, 312, 313 gespeicherte Information erhalten bleiben. Grundsätzlich ist es möglich, die Teilschaltung 300 entgegen dem Ausführungsbeispiel der Fig. 1 mit Bauelementen für die Batteriespannung VB auszubilden, so dass die Teilschaltung im Ruhemodus lediglich mit der Batteriespannung VB für einen Erhalt der gespeicherten Information verbunden werden müsste. In Fig. 1 ist jedoch eine andere Lösung vorgesehen.

Im Ausführungsbeispiel der Fig. 1 ist parallel zum ersten Spannungsregler 100 ein zweiter Spannungsregler 200 geschaltet, der ebenfalls die Versorgungsspannung VDD zur Verfügung stellt und genauso wie der erste Spannungsregler 100 mit der ersten Teilschaltung 100 verbunden ist. Alternativ zu Fig. 1 ist es auch möglich eine Anzahl von Schalter derart zwischen einen Spannungsregler 100 oder 200 und der Teilschaltung 300 zu schalten, dass die Teilschaltung mit dem ersten Spannungsregler 100 und/oder mit dem zweiten Spannungsregler 200 mittels eines Schalters verbindbar ist.

Der zweite Spannungsregler 200 weist einen Eigenstromverbrauch auf, der kleiner als der Eigenstromverbrauch des ersten Spannungsreglers 100 ist. Der erste Spannungsregler 100 stellt einen maximalen Versorgungsstrom bereit, der größer ist als der maximale Versorgungsstrom des zweiten Spannungsreglers 200. Im Ausführungsbeispiel der Fig. 1 sind der erste Spannungsregler 100 und der zweiten Spannungsregler 200 parallel geschaltet.

Im Ausführungsbeispiel der Fig. 1 ist der erste Spannungsregler 100 sowohl durch die Teilschaltung 300 als auch durch eine Rücksetzeinrichtung 500 gesteuert aktivierbar. Beim erstmaligen Hochfahren nach dem Anlegen einer Eingangsspannung VB (Batteriespannung) wird der erste Spannungsregler 100 durch die Rücksetzeinrichtung 500 aktiviert. Eine zum erstmaligen Hochfahren korrespondierende Information wird in einem Speicherelement 510, beispielsweise einem Flip-Flop, der Rücksetzeinrichtung 500 gespeichert. Nachfolgend wird die Steuerfunktion der Aktivierung und Deaktivierung durch die Rücksetzeinrichtung 500 an die Teilschaltung 300 übergeben. Hierzu schaltet die Rücksetzeinrichtung 500 mittels einer Schaltvorrichtung 400 die Verbindung zwischen der Teilschaltung 300 und dem ersten Spannungsregler 100 frei. Die Teilschaltung 300 kann nun ihrerseits die Aktivierung und Deaktivierung des ersten Spannungsreglers 100 mittels des Steuersignals en_vdd steuern. Die Rücksetzeinrichtung 500 ist vorteilhafterweise auch zum Zurücksetzen der Teilschaltung 300 beispielsweise beim erstmaligen Hochfahren ausgebildet.

Die Schaltvorrichtung 400 ist ausgebildet Eingänge E1, E2, E3 der Teilschaltung 300 zu aktivieren und zu deaktivieren. Im Ausführungsbeispiel der Fig. 1 wird diese Schaltfunktion der Aktivierung und Deaktivierung der Eingänge E1, E2, E3 vom ersten Spannungsregler 100 gesteuert, der ein Steuersignal vdd_ok33 zur Aktivierung und Deaktivierung der Eingänge E1, E2, E3 an die Schaltvorrichtung 400 ausgibt.

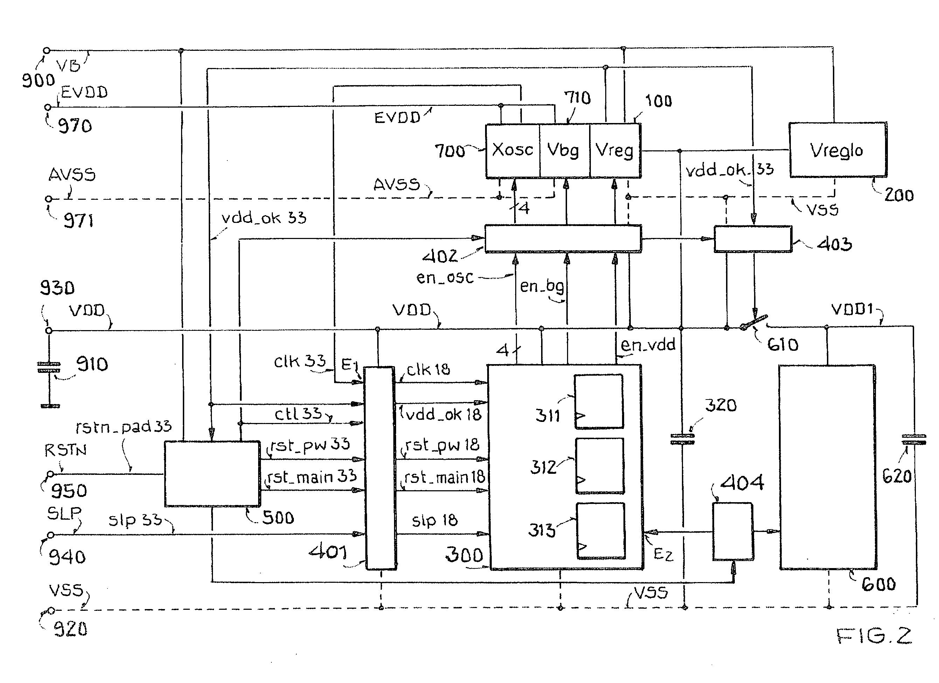

In Fig. 2 ist ein weiteres Ausführungsbeispiel als Blockschaltbild einer Schaltung schematisch dargestellt. Eine Teilschaltung 300 mit Kontrollfunktionen und Testfunktionen wird über die Versorgungsspannungen VDD und VSS versorgt, die mit jeweils einem Anschluss 930 respektive 920 der Schaltung verbunden sind. Parallel zur Teilschaltung 300 ist ein Kondensator 320 geschaltet. Mittels der Anschlüsse 920 und 930 kann ein externer Kondensator 910 zusätzlich parallel geschaltet werden.

Die Versorgungsspannung VDD (ca. 1,8 V) wird aus einer am Anschluss 900 anliegenden Eingangsspannung VB (ca. 3,3 V) durch einen aktivierbaren und deaktivierbaren Spannungsregler 100 (Vreg) erzeugt. Weiterhin sind eine Oszillatorschaltung 700 (Xosc) und eine Bandgab-Referenzspannungsquelle 710 vorgesehen, die mit den Spannungen EVDD und AVSS an den Anschlüssen 970 und 971 versorgt werden.

Die Blöcke 410, 402, 403 und 404 eine Schaltvorrichtung weisen mehrere Funktionen auf. Die Blöcke 401, 402 und 403 weisen Pegelschieber auf, um Signale zwischen einem Potential der Eingangsspannung VB und einem Potential der Versorgungsspannung VDD in die jeweilige Richtung zu übertragen. Die Pegelschieber des Blocks 401 und des Blocks 403 setzen eingehende Signale des Potentials der Eingangsspannung VB auf korrespondierende Signale mit dem Potential der Versorgungsspannung VDD um. Die Pegelschieber des Blocks 402 setzen eingehende Signale des Potentials der Versorgungsspannung VDD auf korrespondierende Signale mit dem Potential der Eingangsspannung VB um.

Weiterhin ist eine Rücksetzeinrichtung 500 vorgesehen, die zum Empfang eines Rücksetzsignals RSTN (engl. reset) mit dem Anschluss 950 verbunden ist. Das Rücksetzsignals RSTN dient dazu die Schaltung unabhängig von dem aktuellen Modus durch das externe Rücksetzsignal RSTN zurückzusetzen. Die Rücksetzeinrichtung 500 weist einen anderen Eingang auf, der mit einem Signalausgang des ersten Spannungsreglers 100 verbunden ist. An dem Signalausgang stellt der erste Spannungsregler ein Statussignal vdd_ok33 bereit, das eine eingeregelte Versorgungsspannung VDD anzeigt.

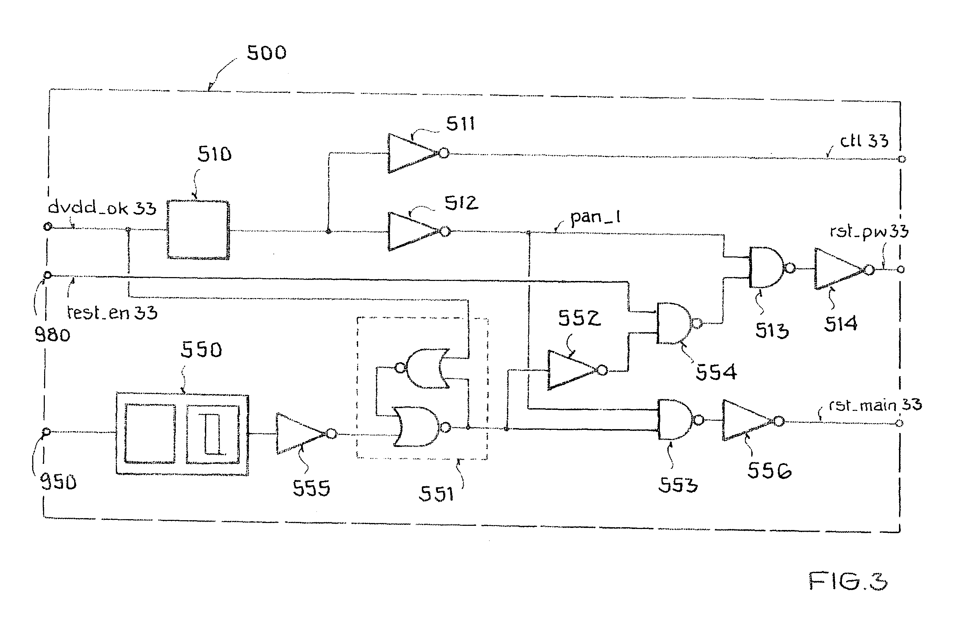

In Abhängigkeit von den zuvor erläuterten Eingangssignalen führt die Rücksetzeinrichtung 500 korrespondierende Rücksetzfunktionen aus. Dies wird im Zusammenhang mit der Fig. 3 näher erläutert. Auch im Ausführungsbeispiel der Fig. 2 wird beim erstmaligen Hochfahren nach dem Anlegen der Eingangsspannung VB (Batteriespannung) der erste Spannungsregler 100 durch die Rücksetzeinrichtung 500 aktiviert. Nachfolgend wird wiederum die Steuerfunktion der Aktivierung und Deaktivierung durch die Rücksetzeinrichtung 500 an die Teilschaltung 300 übergeben. Hierzu gibt die Rücksetzeinrichtung 500 ein Steuersignal an den Block 402 der Schaltvorrichtung auf, so dass die Verbindung zwischen der Teilschaltung 300 und dem ersten Spannungsregler 100 freigeschaltet wird. Die Teilschaltung 300 steuert die Aktivierung und Deaktivierung des ersten Spannungsreglers 100 mittels des Steuersignals en_vdd autark.

Die Teilschaltung 300 ist zur Kontrolle der Aktivierung und Deaktivierung des ersten Spannungsreglers 100 ausgebildet. Durch ein Signal SLP am Anschluss 940 ist die Initiierung eines Ruhemodus möglich, indem der Stromverbrauch der Schaltung gegenüber einem Betriebsmodus reduziert ist. Hierzu gelangt das Signal SLP an den Eingang E4 über den Pegelschieber des Blocks 401 zur Teilschaltung 300. Die Teilschaltung 300 deaktiviert über den Block 402 mittels des Signals en_vdd den ersten Spannungsregler 100. Weiterhin deaktiviert die Teilschaltung 300 mittels des Signals en_bg über den Block 402 die Bandgab-Referenzspannungsquelle 710 und deaktiviert mittels des Signals en_osc die Oszillatorschaltung 700. Alternativ ist es auch möglich, dass die Teilschaltung 300 - beispielsweise nach der Abarbeitung eines Programmablaufs - selbsttätig einen Ruhemodus initiiert.

Das Statussignal vdd_ok33 des deaktivierten ersten Spannungsreglers 100 gelangt an die Blöcke 401 und 403 und an die Rücksetzeinrichtung 500. Dabei wird über den Pegelschieber des Blocks 403 der Schalter 610 angesteuert, dass eine weitere Teilschaltung 600 von der Versorgungsspannung VDD getrennt wird. Parallel zur weiteren Teilschaltung 600 ist wiederum eine Kapazität 620 geschaltet. Die weitere Teilschaltung 600 ist zum Senden und Empfangen von digitalen Daten ausgebildet. Die weitere Teilschaltung 600 wird im Betriebsmodus von dem ersten Spannungsregler 100 mit der Versorgungsspannung VDD versorgt. Hingegen wird die weitere Teilschaltung im Ruhemodus durch den Schalter 610 von der Versorgungsspannung VDD getrennt.

Im Ruhemodus ist lediglich der zweite Spannungsregler 200 (Vreglo) aktiv, der einen gegenüber dem ersten Spannungsregler 100 kleineren, insbesondere um zumindest den Faktor 100 kleineren Stromverbrauch aufweist. Die Versorgungsausgänge des ersten Spannungsreglers 100 und des zweiten Spannungsreglers 200 sind miteinander und mit der Teilschaltung 300 verbunden. Da die Teilschaltung 300 auch im Ruhemodus durch den zweiten Spannungsregler 200 mit der Versorgungsspannung VDD versorgt wird, bleibt die in Speicherelementen 311, 312, 313 enthaltene Information auch im Ruhemodus erhalten. Die Zustände (Low, High) der digitalen Elemente (Gatter usw.) der Teilschaltung 300 verbleiben definiert.

Die Zustände der digitalen Elemente (Gatter usw.) der weiteren Teilschaltung 600 sind aufgrund der Trennung durch den Schalter 610 hingegen nicht definiert. Damit diese nicht definierten Zustände der weiteren Teilschaltung 600 die Teilschaltung 300 nicht beeinflussen, ist im Ausführungsbeispiel der Fig. 2 ein Block 404 der Schaltvorrichtung vorgesehen, der zur Deaktivierung und Aktivierung der Eingänge E2 der Teilschaltung 300 ausgebildet ist. Werden im Ruhemodus die Eingänge E2 durch die Schaltfunktion des Blocks 404 deaktiviert, können keine undefinierten Zustände von der weiteren Teilschaltung 600 zur Teilschaltung 300 gelangen. Ebenso wird der Eingang E1 für das Taktsignal c1k33 durch die Schaltfunktion des Blocks 401 der Schaltvorrichtung im Ruhemodus deaktiviert, so dass kein Taktsignal c1k18 zur Teilschaltung 300 gelangt.

In Fig. 3 ist eine Rücksetzeinrichtung 500 schematisch dargestellt. Diese weist eine Anzahl von Invertern 511, 512, 514, 552, 555, 556, eine Anzahl von NAND-Gattern 513, 553, 554, Flip-Flops 510, 551 und einen Filter 550 auf. Ein zusätzlicher Anschluss 980 ist für Testzwecke vorgesehen. Die Rücksetzeinrichtung 500 weist zwei Funktionen auf. Die Rücksetzeinrichtung 500 generiert ein Rücksetzsignal beim Anlegen der Eingangsspannung VB und filtert ein außerhalb der Schaltung generiertes Rücksetzsignal rstn am Anschluss 950.

Das RS-Flip-Flop 510 weist eine statische und dynamische Unsymmetrie seiner Transistoren auf. Diese Implementierung bewirkt, dass das RS-Flip-Flop 510 in einen definierten Ein-Zustand beim Anlegen der Eingangsspannung VB fällt. Das Ausgangssignal des RS-Flip-Flops 510 zwingt beide Rücksetzausgangssignale zu Low-Potential, was ein Rücksetzen aller Teilschaltungen 300, 600 bewirkt. Das RS-Flip-Flop 510 behält diesen Zustand bei bis die Versorgungsspannung VDD hochgerampt ist. Das Statussignal vdd_ok33 vom ersten Spannungsregler 100 setzt das RS-Flip-Flop 510 zurück und beendet die Rücksetzsignale rst_pw33, rst_main33.

Das externe Signal rstn gelangt durch den Filter 550, welcher die fallende Flanke des Signals verzögert um Spikes auf dem Rücksetzsignal zu vermeiden. Hingegen ist die steigende Flanke nicht verzögert. Das zusätzliche Flip-Flop 551 speichert das Rücksetzereignis im Ruhemodus. Dies ist notwendig, da der Teilschaltung 300 zunächst beim Anlegen der Eingangsspannung VB noch keine Versorgungsspannung VDD zur Verfügung steht. Daher wird nach dem Hochlaufen der Versorgungsspannung VDD und setzt das Statussignal vdd_ok33 des ersten Spannungsreglers 100 das Flip-Flop 551 wieder.

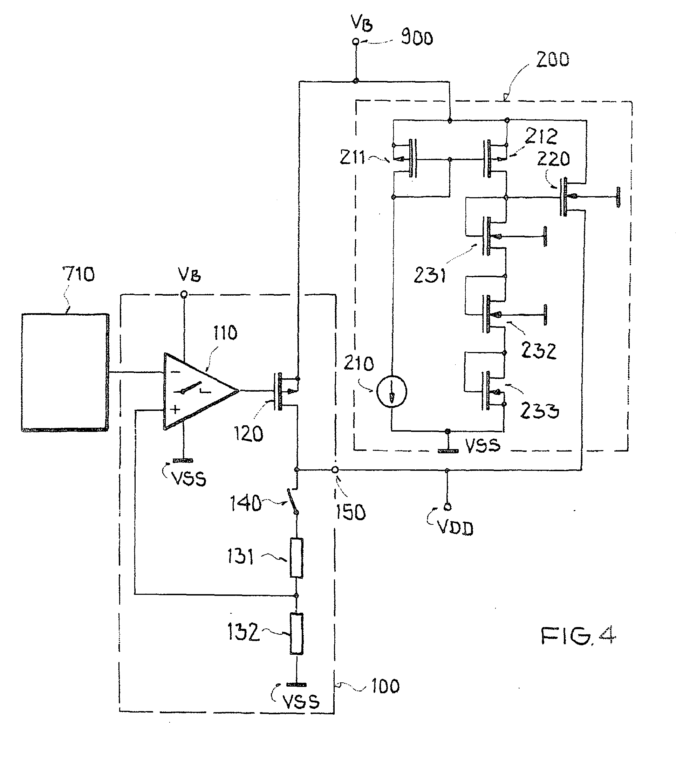

In Fig. 4 sind der erste Spannungsregler 100 und der zweite Spannungsregler 200 in einem Schaltplan schematisch dargestellt.

Der erste Spannungsregler weist einen Operationsverstärker 110 mit Differenzverstärker und Treiberstufe auf, dessen negativer Eingang mit der Bandgab-Referenzspannungsquelle 710 verbunden ist. Die Bandgab-Referenzspannungsquelle 710 stellt dabei eine Referenzspannung von 1,25 V bereit. Der Ausgang des Operationsverstärkers 100 ist mit einem P-MOSFET-Ausgangstransistor 120 verbunden, der für den Versorgungsstrom im Betriebsmodus bis maximal 30 mA ausgelegt ist. Der Ausgang 150 des ersten Spannungsreglers 100 ist mit dem Drain-Anschluss des Transistors 120 verbunden. Weiterhin ist mit dem Drainanschluss des Transistors 120 ein Widerstandsspannungsteiler mit den Widerständen 131 und 132 verbunden, wobei der Mittelabgriff des Widerstandsspannungsteilers mit dem positiven Eingang des Operationsverstärkers 110 verbunden ist.

Diese Verbindung vom Ausgang über den Widerstandsspannungsteiler zu dem Eingang des Operationsverstärkers 110 bildet eine Regelschleife. Diese Regelschleife ermöglicht es Laständerungen am Ausgang 150 im Betriebsmodus auszuregeln. Durch die Regelschleife kann die Versorgungsspannung konstant auf den Wert von 1,8 V geregelt werden.

Der Operationsverstärker 110 ist im Ruhemodus abschaltbar um den ersten Spannungsregler 100 zu deaktivieren. Weiterhin wird der Widerstandsspannungsteiler durch den Schalter 140 im Ruhemodus vom Ausgang 150 getrennt. Der für die Regelschleife benötigte Operationsverstärker 110 bewirkt im Betriebsmodus maßgeblich den Stromverbrauch von 100 µA. Der zweite Spannungsregler 200 ist immer eingeschaltet. Der zweite Spannungsregler 200 weist eine Stromquelle 210 für einen Strom IBIAS auf, der mittels der zwei als Stromspiegel verschalteten PMOS-Transistoren 211, 212 auf die in Reihe geschalteten als MOS-Dioden verschalteten NMOS-Transistoren 231, 232, 233 gespiegelt wird. Die Stromquelle kann beispielsweise eine PTAT-Schaltung sein.

Die über die NMOS-Transistoren 231, 232, 233 abfallende Spannung liegt ebenfalls an dem als Source-Folger geschalteten NMOS-Transistor 220 an, dessen Source mit dem Ausgang des zweiten Spannungsreglers 220 verbunden ist und eine Spannungsregelung bewirkt. Der zweite Spannungsregler 200 stellt dabei die Versorgungsspannung VDD im Ruhemodus beispielsweise in einer Höhe von 1,6 V bereit. Die Versorgungsspannung kann im Ruhemodus in einem Bereich zwischen 1,2 V und 2,0 V liegen, ohne dass die in den Speicherelementen 311, 312, 313 der Teilschaltung 300 gespeicherten Informationen verloren gehen. Die Versorgungsspannung VDD kann daher im Betriebsmodus und von der im Ruhemodus abweichen. Der zweite Spannungsregler 200 weist dabei keine mit dem Ausgang des zweiten Spannungsreglers 200 verbundene Regelschleife auf.

Die Erfindung ist nicht auf die dargestellten Ausgestaltungsvarianten der Figuren 1 bis 4 beschränkt. Beispielsweise ist es möglich andere als die in Fig. 4 erläuterten Spannungsreglerschaltungen zu verwenden. Die Funktionalität des Schaltkreises gemäß Fig. 2 kann besonders vorteilhaft für ein Funknetzsystem insbesondere nach dem Industriestandard IEEE 802.15.4 für einen Batteriebetrieb verwendet werden.

### Bezugszeichenliste

- 100: erster Spannungsregler
- 110: Operationsverstärker
- 120,211,212,220: PMOS-Transistor
- 131, 132: Widerstand
- 140: Halbleiterschalter
- 150: Ausgang
- 200: zweiter Spannungsregler
- 210: Stromquelle, PTAT
- 231, 232, 233: NMOS-Transistor
- 300: Teilschaltung
- 311, 312, 313: Speicherelement
- 320,620,910: Kapazität
- 400: Schaltvorrichtung
- 401, 402, 403: Pegelschieber
- 404: Schalter
- 500: Rücksetzeinrichtung
- 510: RS-Flip-Flop
- 511,512,514,552,555,556: Inverter
- 513, 553, 554: NAND-Gatter
- 550: Filter
- 600: weitere Teilschaltung
- 700: Oszillatorschaltung
- 710: Bandgap-Referenzspannungsquelle
- 900, 920, 930, 940, 950, 970, 971,980: Anschluss

## Patentansprüche

1. Schaltung,
- mit einer Teilschaltung (300), die eine Anzahl von Speicherelementen (311, 312, 313) aufweist,
- mit einem ersten Spannungsregler (100), der zum Betrieb der Teilschaltung (300) mit der Teilschaltung (300) verbindbar oder verbunden ist,
- mit einem zweiten Spannungsregler (200), der zum Erhalt einer in den Speicherelementen (311, 312, 313) enthaltenen Information mit der Teilschaltung (300) verbindbar oder verbunden ist,
- mit einer mit der Teilschaltung (300) verbundenen Schaltvorrichtung (400), die zur Deaktivierung und Aktivierung von Eingängen (E1, E2, E3) der Teilschaltung (300) ausgebildet ist,
- wobei die Schaltung ausgebildet ist die Deaktivierung und Aktivierung der Eingänge (E1, E2, E3) der Teilschaltung (300) zu steuern, und
- wobei die Teilschaltung (300) ausgebildet ist eine Deaktivierung und Aktivierung des ersten Spannungsreglers (100) mittels eines Steuersignals (en_vdd) zu steuern.

2. Schaltung nach Anspruch 1, die ausgebildet ist einen Betriebsmodus mit digitalen Zustandswechseln der Teilschaltung (300) und einen Ruhemodus mit keinem digitalen Zustandswechsel oder einer gegenüber dem Betriebsmodus reduzierten Anzahl von digitalen Zustandswechseln zu steuern.

3. Schaltung nach einem der vorhergehenden Ansprüche,
- mit einer weiteren Teilschaltung (600),
- mit einem Schalter (610), der mit der weiteren Teilschaltung (600) und dem zweiten Spannungsregler (200) verbunden ist,
- wobei die Schaltung ausgebildet ist den Schalter (610) für den Ruhemodus zur Trennung der weiteren Teilschaltung (600) vom zweiten Spannungsregler (200) anzusteuern.

4. Schaltung nach einem der vorhergehenden Ansprüche, bei der die Schaltvorrichtung eine Anzahl von schaltbaren Pegeischiebern (401, 402, 403) aufweist.

5. Schaltung nach einem der vorhergehenden Ansprüche,
- mit einer Rücksetzeinrichtung (500), die zur Ausgabe von Rücksetzsignalen zum Zurücksetzen der Teilschaltung (300) und/oder der weiteren Teilschaltung (600) ausgebildet ist.

6. Schaltung nach Anspruch 5,
- bei der die Rücksetzeinrichtung (500) mit dem ersten Spannungsregler (100) verbunden und ausgebildet ist den ersten Spannungsregler (100) bei einem erstmaligen Anlegen einer Eingangsspannung (VB) an die Schaltung zu aktivieren.

7. Schaltung nach einem der Ansprüche 5 oder 6,
- bei der die Rücksetzeinrichtung (500) ein Speicherelement (510) aufweist, dessen Speicherwert ein erstmaliges Anlegen einer Eingangsspannung (VB) an die Schaltung repräsentiert.

8. Schaltung nach einem der Ansprüche 5 bis 7,
- bei der die Rücksetzeinrichtung (500) zur Freigabe einer Aktivierung des ersten Spannungsreglers (100) durch die Teilschaltung (300) ausgebildet ist.

9. Schaltung nach einem der vorhergehenden Ansprüche, bei der nur der erste Spannungsregler (100) der beiden Spannungsregler (100, 200) eine Regelschleife aufweist, die mit einem Versorgungsspannungsausgang des ersten Spannungsreglers (100) - insbesondere über einen Spannungsteiler (131, 132) - verbunden ist.

10. Verfahren zum Betrieb einer Schaltung,
- bei dem für einen Ruhemodus Eingänge (E1, E2, E3) einer Teilschaltung (300) mit einer Anzahl von Speicherelementen (311, 312, 313) deaktiviert werden,
- bei dem ein erster Spannungsregler (100) nach der Deaktivierung der Eingänge (E1, E2, E3) der Teilschaltung (300) durch die Teüschaltung (300) deaktiviert wird, so dass die Speicherelemente (311, 312, 313) der Teilschaltung (300) von einem zweiten Spannungsregler (200) versorgt werden,
- bei dem für einen dem Ruhemodus folgenden Betriebsmodus der erste Spannungsregler (100) durch die Teilschaltung (300) aktiviert wird um die Teilschaltung (300) zu versorgen, und
- bei dem die Eingänge (E1, E2, E3) der Teilschaltung (300) nach der Aktivierung des ersten Spannungsreglers (100) aktiviert werden.

11. Verwendung eines ersten Spannungsreglers (100) einer Schaltung, der eine Versorgungsspannung (VDD) und einen Betriebsstrom für eine Teilschaltung (300) bereitstellt,
für einen Betriebsmodus und
eines zweiten Spannungsreglers (200) einer Schaltung,
der eine Ruhespannung und einen Ruhestrom für die Teilschaltung (300) bereitstellt,
für einen Ruhemodus,
- wobei der zweite Spannungsregler (200) einen geringeren Stromverbrauch aufweist als der erste Spannungsregler (100), und
- wobei der erste Spannungsregler (100) durch die Teilschaltung (300) aktiviert und deaktiviert wird.
